# EUROPEAN PATENT APPLICATION

(11) **EP 1 277 776 A1**
(43) Date of publication of application: **22.01.2003**
(21) Application number: 02255042.0
(22) Date of filing: 17.07.2002
(51) Int. Cl.: C08G 59/00, C08G 59/68, C08G 65/18, C08G 65/10, G02F 1/1339

(54) **Photocurable resin composition for sealing material and method of sealing**

(30) Priority: 17.07.2001 JP 2001216940; 08.04.2002 JP 2002105515; 08.04.2002 JP 2002105516
(71) Applicant: Mitsui Chemicals, Inc., Tokyo 100 (JP)
(72) Inventor: Takamatsu, Yasushi, Sodegaura-shi, Chiba (JP); Yamamoto, Yugo, Sodegaura-shi, Chiba (JP); Kuwatsuka, Toshiaki, Tokyo (JP); Ikado, Shuhei, Chiba (JP); Mizuta, Yasushi, Chiba (JP); Kikuta, Yoshio, Chiba (JP)
(74) Representative: Nicholls, Kathryn Margaret

(57) **Abstract**

The photocationic-curable resin composition of the invention comprises (A) a cationic-polymerizable compound, (B) a photocationic initiator and (C) an aromatic ether compound or an aliphatic thioether compound. The photocationic-curable resin composition has excellent conversion (curability) at low temperatures, and its cured product exhibits excellent adhesive strength and moisture permeation resistance. According to the sealing material comprising the composition, a liquid crystal display or an electroluminescent display having excellent adhesive strength and moisture permeation resistance can be provided with high productivity.

## Description

The present invention relates to photocationic-curable resin composition and uses thereof, particularly a liquid crystal display sealing material and an electroluminescent display sealing material. Preferred embodiments include a photocationic-curable resin composition that is excellent in adhesion properties, moisture permeation resistance and photocationic polymerizability at low temperatures, and uses of the composition.

### BACKGROUND

Development and manufacturing of flat panel displays using various display elements have been made recently in the electric and electronic industries. Most of the displays are those obtained by sealing a cell that is made of glass or plastic flat panels and contains therein a display element. Typical examples of such displays include a liquid crystal (LC) display and an electroluminescent (EL) display.

The liquid crystal display is usually one obtained by sealing peripheries of two glass substrates with a sealing material and enclosing a liquid crystal therein. As the sealing material, a thermosetting epoxy resin has been heretofore used. However, the thermosetting epoxy resin needs to be thermoset at a high temperature of 150 to 180°C for about 2 hours, so that there is a problem of low productivity.

On the other hand, the EL display is excellent in properties of high luminance, high efficiency and highspeed response and is attracting attention as a flat panel display of the next generation. As the EL element, an inorganic EL element or an organic EL element is available. The inorganic EL element has been put into practical use for a backlight of watch, and the like. The organic EL element is superior to the inorganic EL element in the high luminance, high efficiency, high response and multi-color development but has low heat resistance, and its heat-resistant temperature is in the range of usually about 80 to 100°C. Therefore, when a thermosetting epoxy resin is used as a sealing material to seal the organic EL display, fully cured resin is not available.

To solve such problems as mentioned above, an attempt to develop a photo-curable sealing material capable of undergoing rapid curing at low temperatures has been made. As the photo-curable sealing material, a photoradical-curable sealing material or a photocationic-curable sealing material is usually available.

As the photoradical-curable sealing material, an acrylic resin is mainly used, and there is an advantage that various acrylate monomers or oligomers are employable. The photoradical-curable sealing material, however, is insufficient in the moisture permeation resistance, and hence, decrease of volume shrinkage or further improvement of adhesive force has been required.

On the other hand, as the photocationic-curable sealing material, an epoxy resin is mainly used, and its adhesion properties are relatively good. With respect to the photo-curing properties such as photosensitivity and rapid curability, however, further improvement has been required. Especially in the photocationic polymerization, the polymerization temperature can be usually set within a relatively low range, however, there is a problem that conversion of the polymerizable compound is not increased because of the low polymerization temperature, and hence excellent photosensitivity and rapid curability are hardly obtained. On this account, an attempt to add a compound having a hydroxyl group has been made to enhance the photo-curing properties of the polymerizable compound in the photocationic polymerization. However, a polymer of a high molecular weight cannot be obtained in some cases because of chain transfer due to the hydroxyl group.

Accordingly, there has been desired development of a photocationic-polymerizable resin composition which has a high conversion even in a relatively low temperature range, shows excellent photo-curing properties and is capable of providing a cured product that is excellent in adhesion to the substrate and moisture permeation resistance.

Under such circumstances, the present inventors have earnestly studied to solve such problems as described above. As a result, they have found that a resin composition comprising a cationic-polymerizable compound, a photocationic initiator, and an aromatic ether compound or an aliphatic thioether compound has good curing properties at low temperatures and its cured product has not only good adhesive strength and moisture permeation resistance but also high productivity.
Further, the present inventors have also found that this photocationic-curable resin composition can be favorably used for flat panels of liquid crystal displays, electroluminescent displays and the like. Based on the finding, the present invention has been accomplished.

It is an object of the invention to provide a photocationic-curable resin composition having good polymerization conversion at low temperatures, good adhesive strength and moisture permeation resistance, and capable of providing a cured product of high productivity.

It is another object of the invention to provide a sealing material suitable for a flat panel of a liquid crystal display or an electroluminescent display, and to provide a liquid crystal display or an electroluminescent display using the sealing material, a liquid crystal display sealing method or an electroluminescent display sealing method using the sealing material, and a process for producing a liquid crystal display or an electroluminescent display using the sealing material.

According to one aspect of the present invention a photocationic-curable resin composition is provided comprising; (A) a cationic-polymerizable compound, (B) a photocationic initiator and (C) an aromatic ether compound (c-1) or an aliphatic thioether compound (c-2).

The aromatic ether compound (c-1) is preferably at least one aromatic ether compound selected from the group consisting of compounds represented by the following formulas (I), (II) and (III).

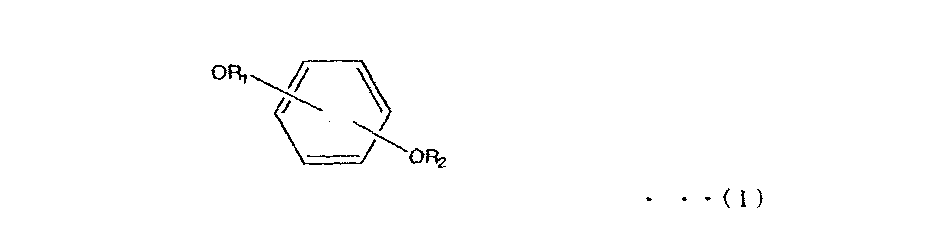

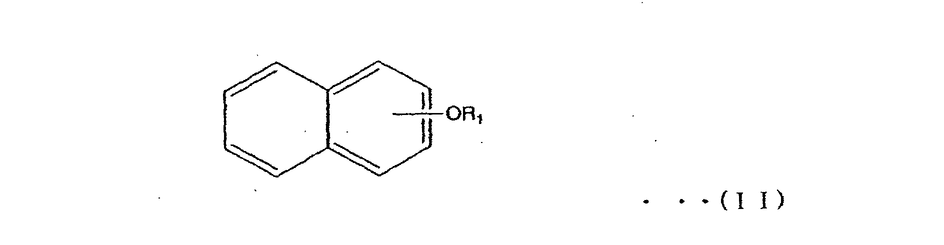

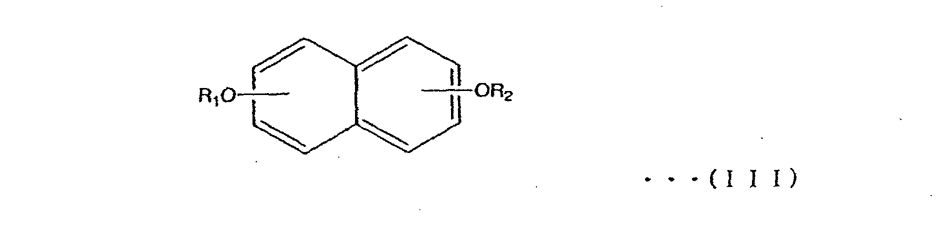

In the formulas (I), (II) and (III), R₁ and R₂ are each an alkyl group of 1 to 5 carbon atoms, a glycidyl group or a 3-ethyl-3-oxetanylmethyl group, and in the formulas (I) and (III), R₁ and R₂ may be the same or different.

The aliphatic thioether compound (c-2) is preferably a compound represented by the following formula (IV).

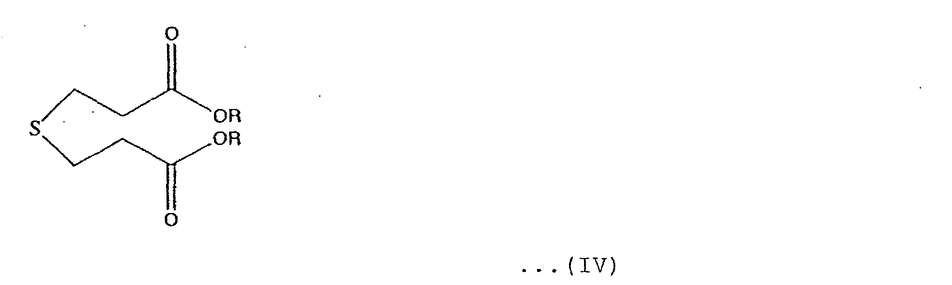

In the formula (IV), R is an alkyl group of 1 to 18 carbon atoms.

The cationic-polymerizable compound (A) is preferably an epoxy compound and/or an oxetane compound.

The aromatic ether compound or the aliphatic thioether compound (C) is preferably contained in an amount of 0.01 to 5 mass parts based on 100 mass parts of the photocationic-curable resin composition.

The photocationic-curable resin composition may further comprise (D) a fine particle inorganic filler.

The photocationic-curable resin composition may further comprise (E) a silane coupling agent.

It is preferable that the cationic-polymerizable compound (A) is contained in an amount of 5 to 99.8 mass parts, the photocationic initiator (B) is contained in an amount of 0.1 to 10 mass parts, the aromatic ether compound or the aliphatic thioether compound (C) is contained in an amount of 0.01 to 5 mass parts, the fine particle inorganic filler (D) is contained in an amount of 0 to 70 mass parts, and the silane coupling agent (E) is contained in an amount of 0 to 10 mass parts, each amount being based on 100 mass parts of the photocationic-curable resin composition.

The liquid crystal display sealing material according to the invention comprises the photocationic-curable resin composition.

The liquid crystal display sealing method according to the invention is a method comprising bonding opposite substrates for a liquid crystal display to each other with a sealing material, wherein the above-mentioned liquid crystal display sealing material is used as the sealing material.

The process for producing a liquid crystal display according to the invention is a process including a step of bonding opposite substrates for a liquid crystal display to each other with a sealing material, wherein the above-mentioned liquid crystal display sealing material is used as the sealing material.

The liquid crystal display according to the invention is a display using the above-mentioned liquid crystal display sealing material as a sealing material to bond opposite substrates for a liquid crystal display.

The electroluminescent display sealing material according to the invention comprises the photocationic-curable resin composition.

The electroluminescent display sealing method according to the invention is a method comprising bonding opposite substrates for an electroluminescent display to each other with a sealing material, wherein the above-mentioned electroluminescent display sealing material is used as the sealing material.

The process for producing an electroluminescent display according to the invention is a process including a step of bonding opposite substrates for an electroluminescent display to each other with a sealing material, wherein the above-mentioned electroluminescent display sealing material is used as the sealing material.

The electroluminescent display according to the invention is a display using the above-mentioned electroluminescent display sealing material as a sealing material to bond opposite substrates for an electroluminescent display.

The present invention is described in more detail hereinafter.

### (A) Cationic-polymerizable compound

The cationic-polymerizable compound (A) in the invention is, for example, an epoxy compound or an oxetane compound.

Examples of the epoxy compounds having one epoxy group include phenyl glycidyl ether and butyl glycidyl ether. Examples of the epoxy compounds having two epoxy groups include hexanediol diglycidyl ether, tetraethylene glycol diglydidyl ether, trimethylolpropane triglycidyl ether, bisphenol A diglycidyl ether, bisphenol F diglycidyl ether and a novolak type epoxy compound.

Examples of the epoxy compounds having an alicylic epoxy group include a compound represented by the following formula (1) and a compound represented by the following formula (2).

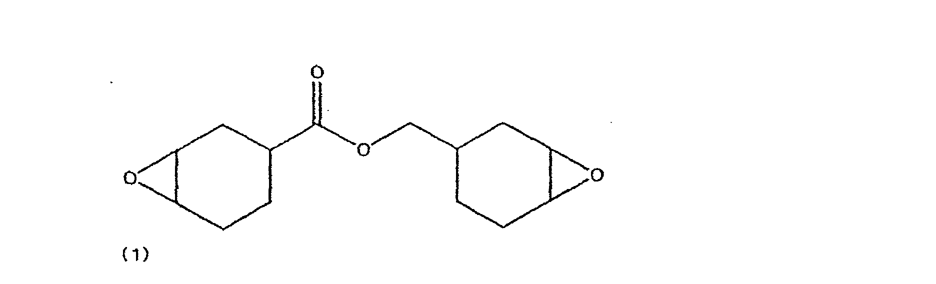

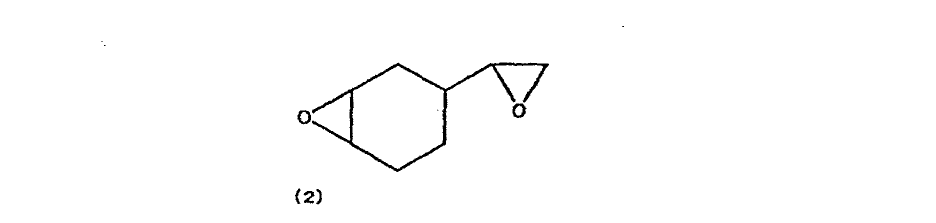

As the oxetane compound, any compound is employable provided that the compound has at least one oxetane ring represented by the following formula (3).

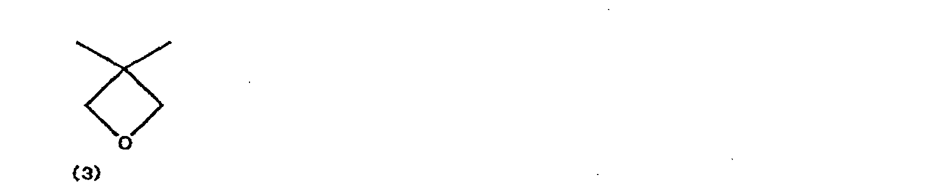

For example, preferable is a compound having 1 to 15 oxetane rings, more preferable is a compound having 1 to 10 oxetane rings, and particularly preferable is a compound having 1 to 4 oxetane rings.

### Compound having one oxetane ring

The compound having one oxetane ring is, for example, a compound represented by the following formula (4).

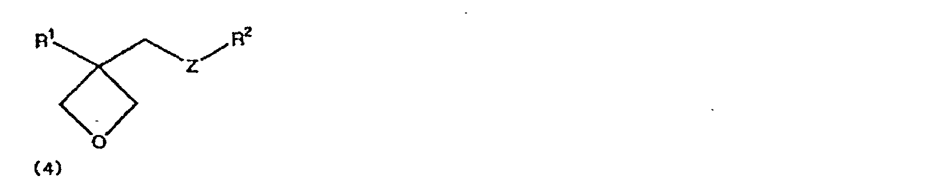

In the formula (4), each of Z, R¹ and R² means the following atoms or substituents.
Z is an oxygen atom or a sulfur atom.
R¹ is a hydrogen atom, a fluorine atom, an alkyl group of 1 to 6 carbon atoms, such as methyl, ethyl, propyl, butyl, pentyl or hexyl, a fluoroalkyl group of 1 to 6 carbon atoms, such as trifluoromethyl, perfluoromethyl, perfluoroethyl or perfluoropropyl, an aryl group of 6 to 18 carbon atoms, such as phenyl or naphthyl, a furyl group, or a thienyl group.
R² is a hydrogen atom, an alkyl group of 1 to 6 carbon atoms, such as methyl, ethyl, propyl, butyl, pentyl or hexyl, an alkenyl group of 2 to 6 carbon atoms, such as 1-propenyl, 2-propenyl, 2-methyl-1-propenyl, 2-methyl-2-propenyl, 1-butenyl, 2-butenyl or 3-butenyl, a substituted or unsubstituted aralkyl group of 7 to 18 carbon atoms, such as benzyl, fluorobenzyl, methoxybenzyl, phenethyl, styryl, cinnamyl or ethoxybenzyl, a group having another aromatic ring, e.g., an aryloxyalkyl group, such as phenoxymethyl or phenoxyethyl, an alkylcarbonyl group of 2 to 6 carbon atoms, such as ethylcarbonyl, propylcarbonyl or butylcarbonyl, an alkoxycarbonyl group of 2 to 6 carbon atoms, such as ethoxycarbonyl, propoxycarbonyl or butoxycarbonyl, or a N-alkylcarbamoyl group of 2 to 6 carbon atoms, such as ethylcarbamoyl, propylcarbamoyl, butylcarbamoyl or pentylcarbamoyl.

In this compound, substituents other than the above substituents may be used within limits not detrimental to the effects of the present invention.

Particular examples of the compounds having one oxetane ring include 3-ethyl-3-hydroxymethyloxetane, 3-(meth)allyloxymethyl-3-ethyloxetane, (3-ethyl-3-oxetanylmethoxy)methylbenzene, 4-fluoro-[1-(3-ethyl-3-oxetanylmethoxy)methyl]benzene, 4-methoxy-[1-(3-ethyl-3-oxetanylmethoxy)methyl]benzene, [1-(3-ethyl-3-oxetanylmethoxy)ethyl]phenyl ether, isobutoxymethyl(3-ethyl-3-oxetanylmethyl) ether, isobornyloxyethyl(3-ethyl-3-oxetanylmethyl) ether, isobornyl(3-ethyl-3-oxetanylmethyl) ether, 2-ethylhexyl(3-ethyl-3-oxetanylmethyl) ether, ethyldiethylene glycol (3-ethyl-3-oxetanylmethyl) ether, dicyclopentadiene (3-ethyl-3-oxetanylmethyl) ether, dicyclopentenyloxyethyl(3-ethyl-3-oxetanylmethyl) ether, dicyclopentenylethyl(3-ethyl-3-oxetanylmethyl) ether, tetrahydrofurfuryl(3-ethyl-3-oxetanylmethyl) ether, tetrabromophenyl(3-ethyl-3-oxetanylmethyl) ether, 2-tetrabromophenoxyethyl(3-ethyl-3-oxetanylmethyl) ether, tribromophenyl(3-ethyl-3-oxetanylmethyl) ether, 2-tribromophenoxyethyl(3-ethyl-3-oxetanylmethyl) ether, 2-hydroxyethyl(3-ethyl-3-oxetanylmethyl) ether, 2-hydroxypropyl(3-ethyl-3-oxetanylmethyl) ether, butoxyethyl(3-ethyl-3-oxetanylmethyl) ether, pentachlorophenyl(3-ethyl-3-oxetanylmethyl) ether, pentabromophenyl(3-ethyl-3-oxetanylmethyl) ether and bornyl(3-ethyl-3-oxetanylmethyl) ether.

### Compound having two oxetane rings

The compound having two oxetane rings is, for example, a compound represented by the following formula (5) or (6).

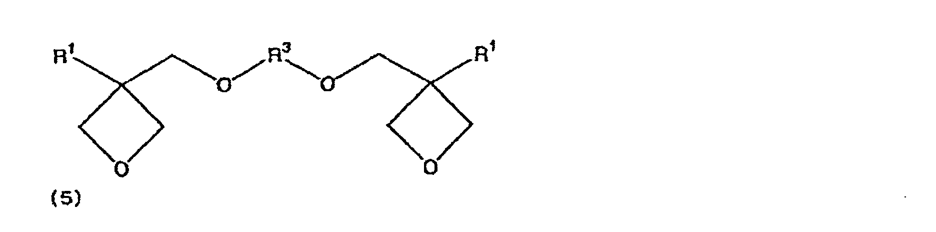

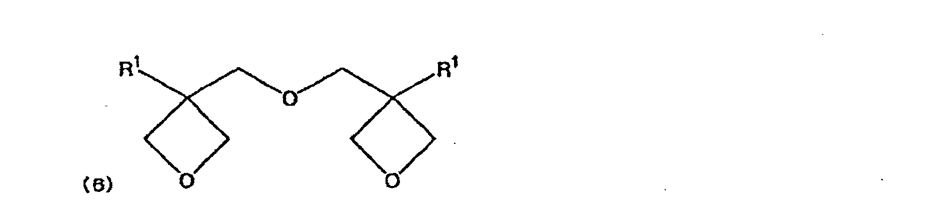

In the formulas (5) and (6), R¹ is similar to that in the formula (4) and is a hydrogen atom, a fluorine atom, an alkyl group of 1 to 6 carbon atoms, such as methyl, ethyl, propyl, butyl, pentyl or hexyl, a fluoroalkyl group of 1 to 6 carbon atoms, such as trifluoromethyl, perfluoromethyl, perfluoroethyl or perfluoropropyl, an aryl group of 6 to 18 carbon atoms, such as phenyl or naphthyl, a furyl group, or a thienyl group. Each R¹ in the formula (5) or (6) may be the same or different.

In the formula (5), R³ is a linear or branched alkylene group of 1 to 20 carbon atoms, such as ethylene, propylene or butylene, a linear or branched poly(alkyleneoxy) group of 1 to 12 carbon atoms, such as poly(ethyleneoxy) or poly(alkyleneoxy), a linear or branched unsaturated hydrocarbon group, such as propenylene, methylpropenylene or butenylene, a carbonyl group, an alkylene group having a carbonyl group, or an alkylene group having a carbamoyl group midway the molecular chain.

R³ may be a polyvalent group selected from groups represented by the following formulas (7), (8), (9) and (10).

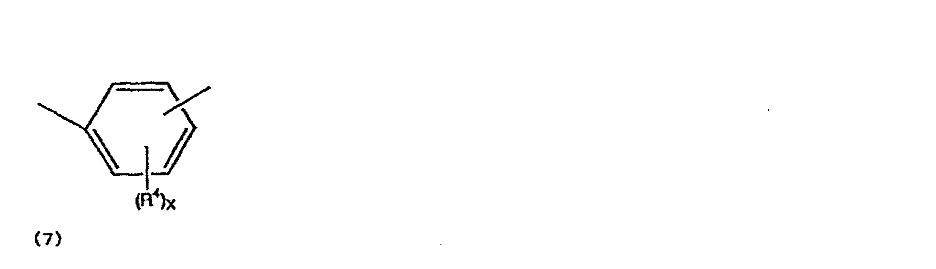

In the formula (7), R⁴ is a hydrogen atom, an alkyl group of 1 to 4 carbon atoms, such as methyl, ethyl, propyl or butyl, an alkoxy group of 1 to 4 carbon atoms, such as methoxy, ethoxy, propoxy or butoxy, a halogen atom, such as chlorine or bromine, a nitro group, a cyano group, a mercapto group, a lower alkylcarboxyl group, a carboxyl group, or a carbamoyl group. x is an integer of 1 to 4.

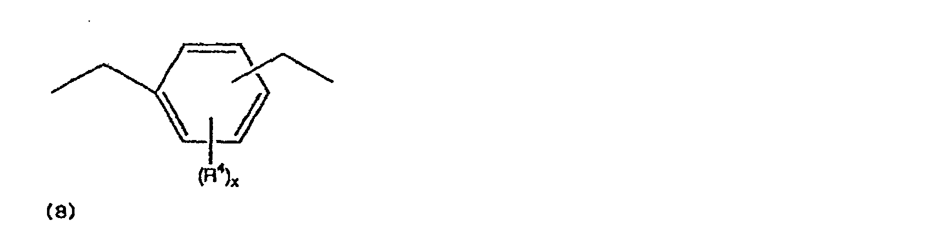

In the formula (8), R⁴ is a hydrogen atom, an alkyl group of 1 to 4 carbon atoms, such as methyl, ethyl, propyl or butyl, an alkoxy group of 1 to 4 carbon atoms, such as methoxy, ethoxy, propoxy or butoxy, a halogen atom, such as chlorine or bromine, a nitro group, a cyano group, a mercapto group, a lower alkylcarboxyl group, a carboxyl group, or a carbamoyl group. x is an integer of 1 to 4.

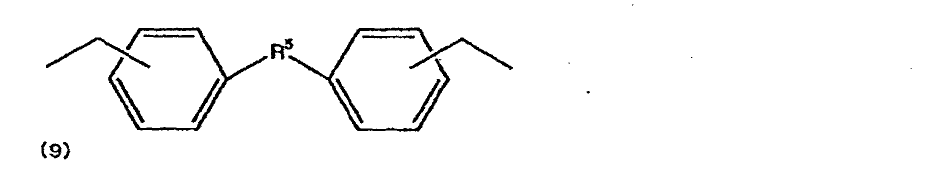

In the formula (9), R⁵ is an oxygen atom, a sulfur atom, a methylene group, -NH-, -SO-, -SO₂-, -C(CF₃)₂- or - C(CH₃)₂-.

The formula (10) represents the following substituent.

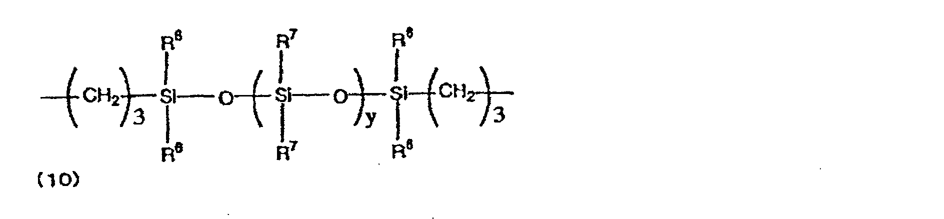

In the formula (10), R⁶ is an alkyl group of 1 to 4 carbon atoms, such as methyl, ethyl, propyl or butyl, or an aryl group of 6 to 18 carbon atoms, such as phenyl or naphthyl. y is an integer of 0 to 200. R⁷ is an alkyl group of 1 to 4 carbon atoms, such as methyl, ethyl, propyl or butyl, or an aryl group of 6 to 18 carbon atoms, such as phenyl or naphthyl.

R⁷ may be a group represented by the formula (11).

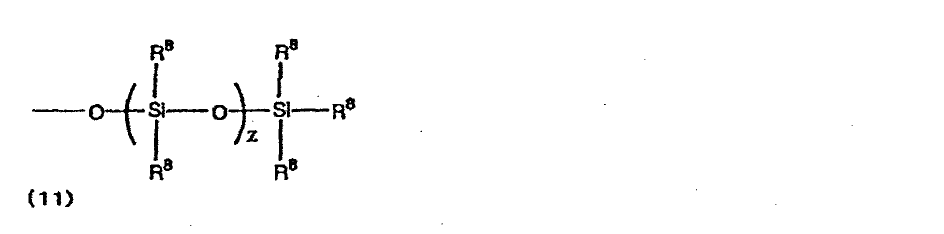

In the formula (11), R⁸ is an alkyl group of 1 to 4 carbon atoms, such as methyl, ethyl, propyl or butyl, or an aryl group of 6 to 18 carbon atoms, such as phenyl or naphthyl. z is an integer of 0 to 100.

More specifically, the compound having two oxetane rings is, for example, a compound represented by the formula (12) or (13).

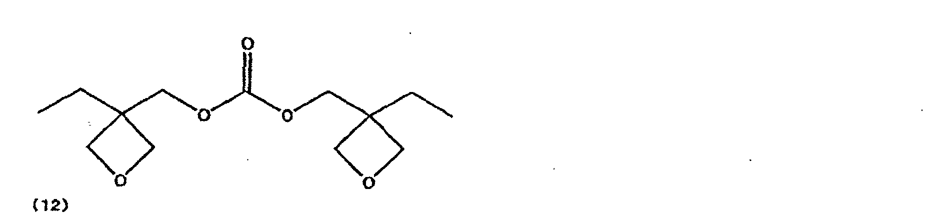

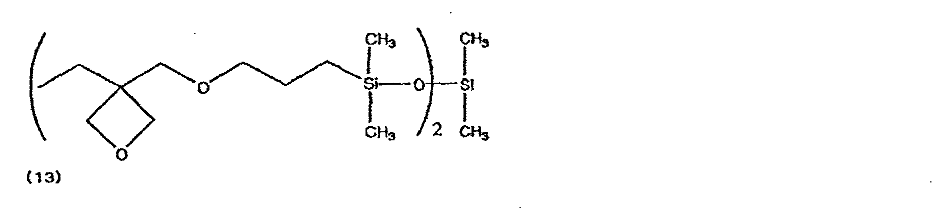

Particular examples of the compounds having two oxetane rings include 3,7-bis(3-oxetanyl)-5-oxa-nonane, 1,4-bis[(3-ethyl-3-oxetanylmethoxy)methyl]benzene, 1,2-bis[(3-ethyl-3-oxetanylmethoxy)methyl]ethane, 1,2-bis[(3-ethyl-3-oxetanylmethoxy)methyl]propane, ethylene glycol bis(3-ethyl-3-oxetanylmethyl) ether, dicyclopentenylbis(3-ethyl-3-oxetanylmethyl) ether, triethylene glycol bis(3-ethyl-3-oxetanylmethyl) ether, tetraethylene glycol bis(3-ethyl-3-oxetanylmethyl) ether, tricyclodecanediyldimethylene bis(3-ethyl-3-oxetanylmethyl) ether, 1,4-bis[(3-ethyl-3-oxetanylmethoxy)methyl]butane, 1,6-bis[(3-ethyl-3-oxetanylmethoxy)methyl]hexane, polyethylene glycol bis(3-ethyl-3-oxetanylmethyl) ether, EO modified bisphenol A bis(3-ethyl-3-oxetanylmethyl) ether, PO modified bisphenol A bis(3-ethyl-3-oxetanylmethyl) ether, EO modified hydrogenated bisphenol A bis(3-ethyl-3-oxetanylmethyl) ether, PO modified hydrogenated bisphenol A bis(3-ethyl-3-oxetanylmethyl) ether, and EO modified bisphenol F bis(3-ethyl-3-oxetanylmethyl) ether.

### Compound having three or more oxetane rings

The compound having three or more oxetane rings is, for example, a compound represented by the formula (14), (21) or (22).

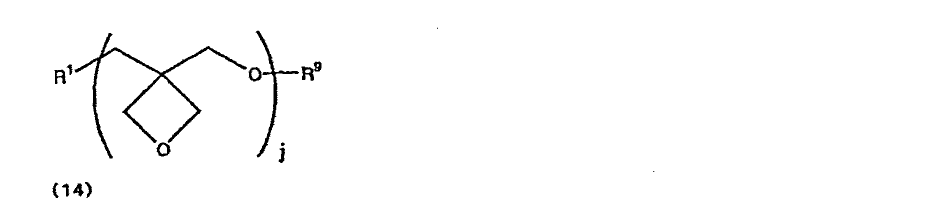

In the formula (14), R¹ is similar to that in the formula (4) and is a hydrogen atom, a fluorine atom, an alkyl group of 1 to 6 carbon atoms, such as methyl, ethyl, propyl, butyl, pentyl or hexyl, a fluoroalkyl group of 1 to 6 carbon atoms, such as trifluoromethyl, perfluoromethyl, perfluoroethyl or perfluoropropyl, an aryl group of 6 to 18 carbon atoms, such as phenyl or naphthyl, a furyl group, or a thienyl group. Each R¹ in the formula (14) may be the same or different.

R⁹ is an trivalent to decavalent organic group, for example, a branched or linear alkylene group of 1 to 30 carbon atoms, such as a group represented by the following formula (15), (16) or (17), a branched poly(alkyleneoxy) group, such as a group represented by the following formula (18), or a linear or branched polysiloxane-containing group represented by the following formula (19) or (20).

In the formula (14), j is an integer of 3 to 10 that is equal to a valence of R⁹.

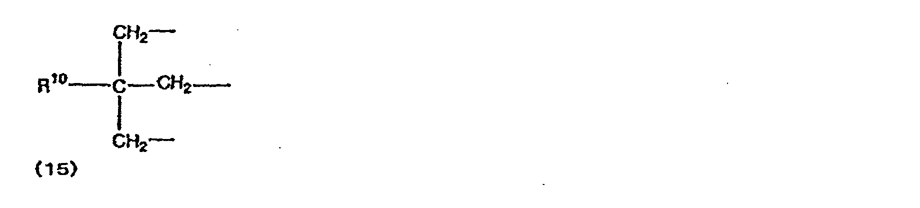

In the formula (15), R¹⁰ is an alkyl group of 1 to 6 carbon atoms, such as methyl, ethyl, propyl, butyl, pentyl or hexyl.

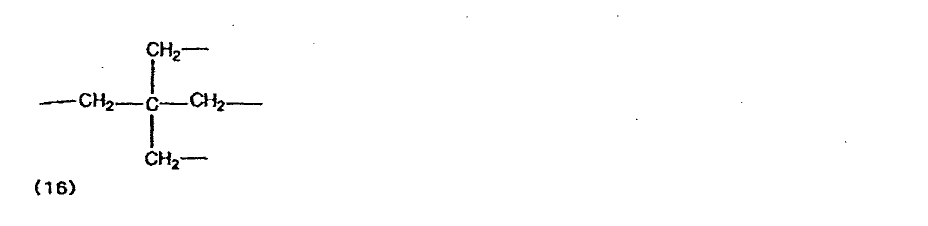

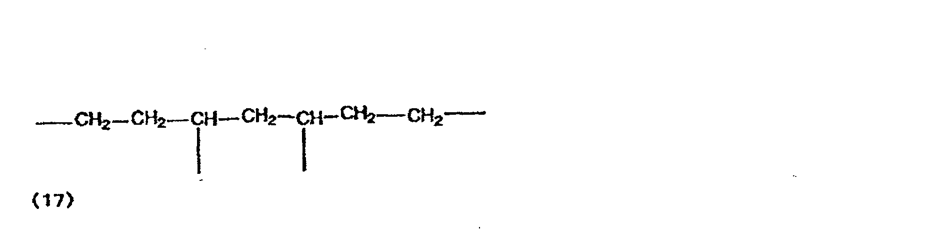

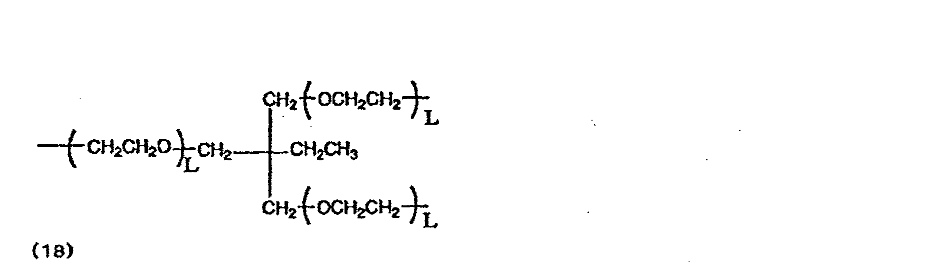

In the formula (18), L is an integer of 1 to 10, and each L may be the same or different.

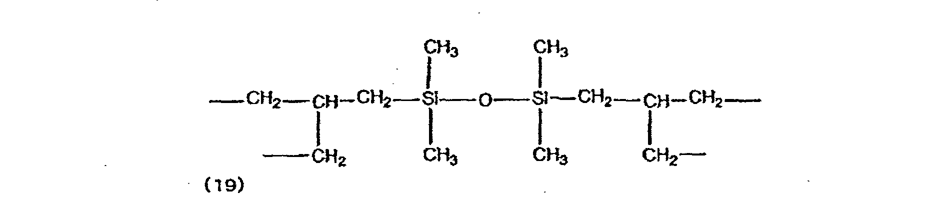

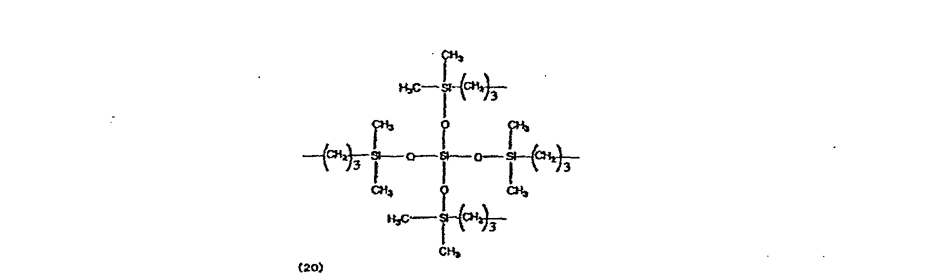

More specifically, the compound having three or more oxetane rings is, for example, a compound represented by the formula (21) or (22).

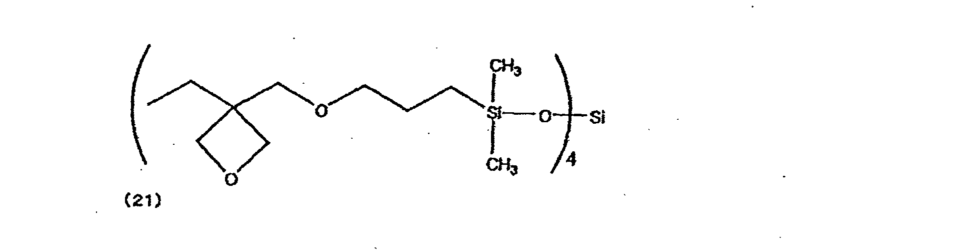

The compound represented by the formula (22) has 1 to 10 oxetane rings and is as follows.

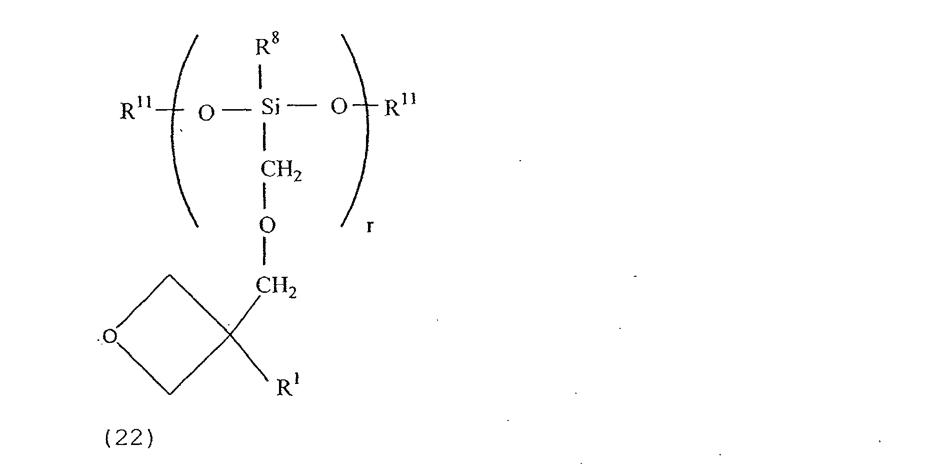

In the formula (22), R¹ is similar to that in the formula (4) and is a hydrogen atom, a fluorine atom, an alkyl group of 1 to 6 carbon atoms, such as methyl, ethyl, propyl, butyl, pentyl or hexyl, a fluoroalkyl group of 1 to 6 carbon atoms, such as trifluoromethyl, perfluoromethyl, perfluoroethyl or perfluoropropyl, an aryl group of 6 to 18 carbon atoms, such as phenyl or naphthyl, a furyl group, or a thienyl group. Each R¹ in the formula (22) may be the same or different.
R⁸ is similar to that in the formula (11) and is an alkyl group of 1 to 4 carbon atoms, such as methyl, ethyl, propyl or butyl, or an aryl group of 6 to 18 carbon atoms, such as phenyl or naphthyl. Each R⁸ may be the same or different.
R¹¹ is an alkyl group of 1 to 4 carbon atoms, such as methyl, ethyl, propyl or butyl, or a trialkylsilyl group of 3 to 12 carbon atoms wherein each alkyl group in the trialkylsilyl group may be the same or different, such as trimethylsilyl, triethylsilyl, tripropylsilyl or tributylsilyl.
r is an integer of 1 to 10.

Particular examples of the compounds having three or more oxetane rings include trimethylpropane tris(3-ethyl-3-oxetanylmethyl) ether, pentaerythritol tris(3-ethyl-3-oxetanylmethyl) ether, pentaerythritol tetrakis(3-ethyl-3-oxetanylmethyl) ether, dipentaerythritol hexakis(3-ethyl-3-oxetanylmethyl) ether, dipentaerythritol pentakis(3-ethyl-3-oxetanylmethyl) ether, dipentaerythritol tetrakis(3-ethyl-3-oxetanylmethyl) ether, caprolactone modified dipentaerythritol hexakis(3-ethyl-3-oxetanylmethyl) ether, and ditrimethylolpropane tetrakis(3-ethyl-3-oxetanylmethyl) ether.

### High-molecular weight compound

As the compound (A) having an oxetane ring, a compound having a number-average molecular weight, as measured by gel permeation chromatography, of about 1000 to 5000 in terms of polystyrene is also available.

A compound represented by the following formula (23), (24) or (25) is exemplified. 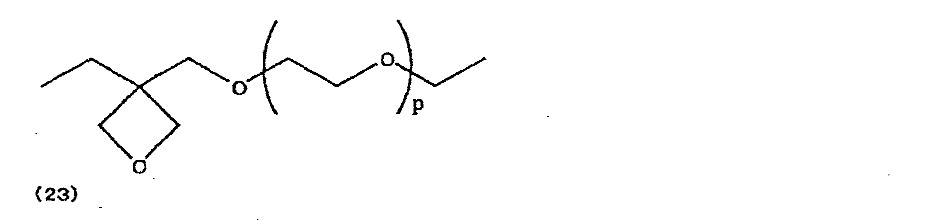 wherein p is an integer of 20 to 200. 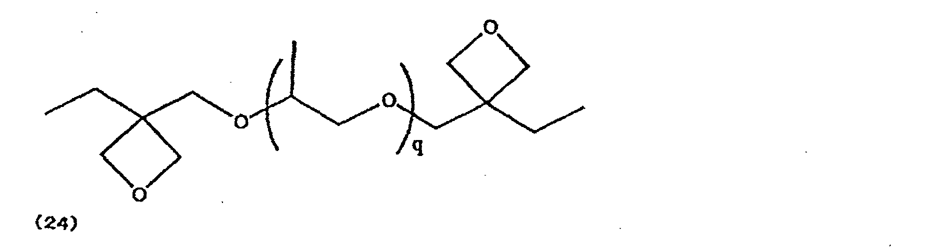 wherein q is an integer of 15 to 200. 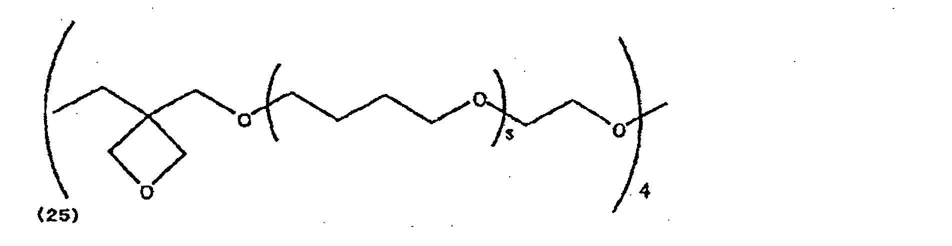 wherein s is an integer of 20 to 200.

The compounds having an oxetane ring can be used singly or in combination of two or more kinds.

The cationic-polymerizable compound (A) for the resin composition of the invention is desired to be used in an amount of preferably 5 to 99.8 mass parts, more preferably 5 to 99.6 mass parts, still more preferably 10 to 90 mass parts, particularly preferably 30 to 90 mass parts, most preferably 50 to 90 mass parts, in 100 mass parts of the photocationic-curable resin composition.

When the amount of the cationic-polymerizable compound (A) is 30 mass parts or more, the composition has excellent photosensitivity and rapid curability, so that such an amount is preferable.

Examples of other cationic-polymerizable compounds include an oxolan compound, a cyclic acetal compound, a cyclic lactone compound, a thiirane compounds, a thietane compound, a spiroorthoester compound, a vinyl ether compound, an ethylenically unsaturated compound, a cyclic ether compound, a cyclic thioether compound and a vinyl compound.

These compounds may be used singly or in comibination of plural kinds.

### (B) Photocationic initiator

As the photocationic initiator (B) in the invention, a compound that initiates cationic polymerization of the resin component (A) is employable without any restriction.

A preferred example of the photocationic initiator is an onium salt having a structure represented by the following formula (26).

This onium salt is a compound which undergoes photo reaction to release Lewis acid.

[R¹² ₐR¹³ _{b}R¹⁴ _{c}R¹⁵ _{d}W]^{m+}[MXₙ₊ₘ]^{m-} (26)

In the above formula, the cation is an onium ion; W is S, Se, Te, P, As, Sb, Bi, O, I, Br, Cl or N=N; R¹², R¹³, R¹⁴ and R¹⁵ are organic groups which are the same as or different from each other; a, b, c and d are each an integer of 0 to 3; and a+b+c+d equals to (valence of W)+m.

M is a metal or a metalloid to constitute a central atom of the halogenated complex [MXₙ₊ₘ], such as B, P, As, Sb, Fe, Sn, Bi, Al, Ca, In, Ti, Zn, Sc, V, Cr, Mn or Co.

X is a halogen atom, such as F, Cl or Br, m is a net electrical charge of the halogenated complex, and n is a valence of M.

Examples of the onium ions in the formula (26) include diphenyliodonium, 4-methoxydiphenyliodonium, bis(4-methylphenyl)iodonium, bis(4-tertbutylphenyl)iodonium, bis(dodecylphenyl)iodonium, triphenylsulfonium, diphenyl-4-thiophenoxyphenylsulfonium, bis[4-(diphenylsulfonio)-phenyl]sulfide, bis[4-(di(4-(2-hydroxyethyl)phenyl) sulfonio) -phenyl] sulfide and η5-2,4-(cyclopentadienyl)[1,2,3,4,5,6-η-(methylethyl)benzene]-iron(1+).

Examples of the anions in the formula (26) include tetrafuloroborate, hexafluorophosphate, hexafluoroantimonate, hexafluoroarsenate and hexachloroantimonate.

In the formula (26), the halogenated complex [MXₙ₊ₘ] as the anion may be replaced with, for example, a perchloric acid ion, a trifluoromethanesulfonic acid ion, a toluenesulfonic acid ion or a trinitrotoluenesulfonic acid ion.

In the formula (26), the halogenated complex [MXₙ₊ₘ] as the anion may be further replaced with an aromatic anion. Examples of the aromatic anions include tetra(fluorophenyl)borate, tetra(difluorophenyl)borate, tetra(trifluorophenyl)borate, tetra(tetrafluorophenyl)borate, tetra(pentafluorophenyl)borate, tetra(perfluorophenyl)borate, tetra(trifluoromethylphenyl)borate and tetra(di(trifluoromethyl)phenyl)borate.

These photocationic initiators can be used singly or in combination of two or more kinds.

The photocationic initiator (B) for the resin composition of the invention is desired to be used in an amount of preferably 0.1 to 10 mass parts, more preferably 0.3 to 4 mass parts, particularly preferably 0.3 to 3 mass parts, in 100 mass parts of the photocationic-curable resin composition. By the use of the photocationic initiator (B) in an amount of 0.1 mass part or more, curing of the resin composition is improved, and from the viewpoint of preventing elution of the photocationic initiator, the amount thereof is preferably 10 mass parts or less.

### (C) Aromatic ether compound or aliphatic thioether compound

The photocationic-curable resin composition according to the invention contains an aromatic ether compound or an aliphatic thioether compound (C).

The aromatic ether compound (c-1) is preferably at least one aromatic ether compound selected from the group consisting of compounds represented by the following formulas (I), (II) and (III).

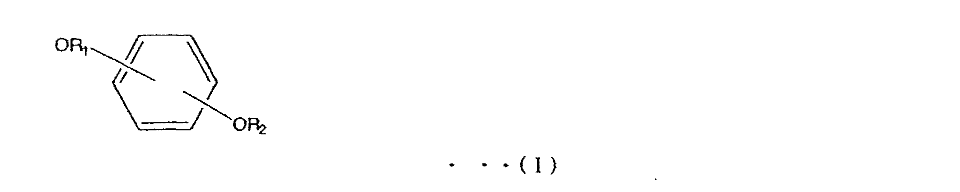

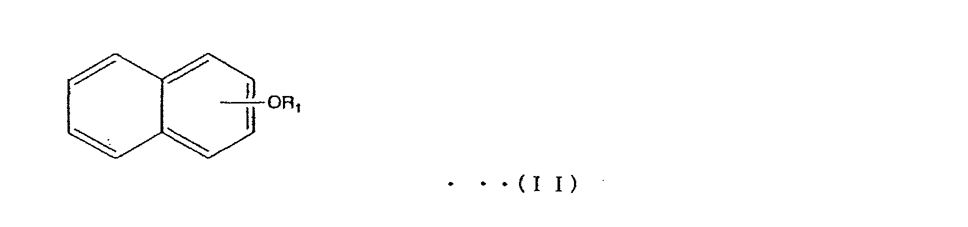

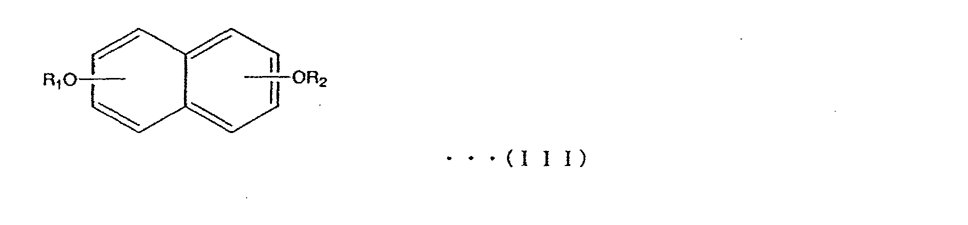

In the formulas (I), (II) and (III), R₁ and R₂ are each an alkyl group of 1 to 5 carbon atoms, a glycidyl group or a 3-ethyl-3-oxetanylmethyl group, and in the formulas (I) and (III), R₁ and R₂ may be the same or different.

As each of R₁ and R₂, an alkyl group of 1 to 3 carbon atoms, a glycidyl group or a 3-ethyl-3-oxetanylmethyl group is preferably employed.

As the aromatic ether compound represented by the formula (I), a compound wherein two substituents -OR₁ and -OR₂ are present at para-positions to each other is preferable.

R₁ and R₂ are preferably the same functional groups as each other.

The aromatic ether compound (c-1) may be an aromatic ether compound having a substituent represented by the aforesaid -OR₁ (or -OR₂) other than the compounds represented by the formulas (I) to (III). Examples of such aromatic ether compounds include benzene having one substituent represented by the aforesaid -OR₁, and hydroanthraquinone dialkyl ether, anthracene and pyrene each having a substituent represented by the aforesaid - OR₁.

A preferred example of the aliphatic thioether compound (c-2) is a compound represented by the following formula (IV).

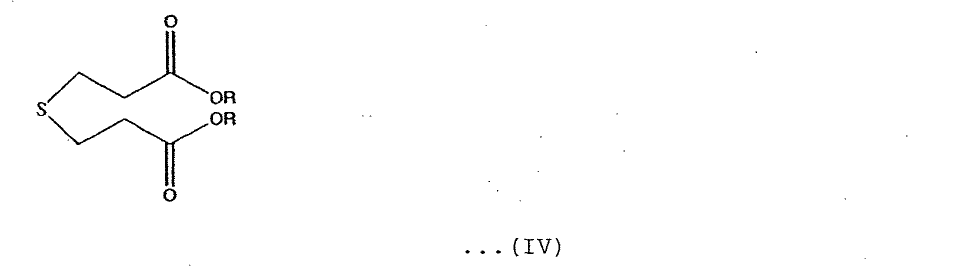

In the formula (IV), R is preferably an alkyl group of 1 to 18 carbon atoms, more preferably an alkyl group of 6 to 18 carbon atoms.

When the aromatic ether compound or the aliphatic thioether compound (C) having such a substituent as mentioned above is used in the polymerization using the photocationic initiator (B) for the cationic-polymerizable compound (A), the conversion of the cationic-polymerizable compound in the low-temperature region, e.g., 0 to 100°C, particularly 20 to 100°C, is improved, and besides a cured product thereof exhibits excellent adhesive strength and moisture permeation resistance.

The aromatic ether compound or the aliphatic thioether compound represented by any one of (I) to (IV) may further has a different substituent in addition to the substituent represented by -OR₁, -OR₂ or OR, within limits not detrimental to the effects of the present invention. Examples of such substituents include an alkyl group of 1 to 5 carbon atoms, preferably 1 to 3 carbon atoms, an ester group and a hydroxyl group.

The above-mentioned aromatic ether compounds or the aliphatic thioether compounds (C) can be used singly or in combination of two or more kinds.

The aromatic ether compound or the aliphatic thioether compound (C) is desired to be used in an amount of preferably 0.01 to 5 mass parts, more preferably 0.05 to 3 mass parts, particularly preferably 0.1 to 3 mass parts, based on 100 mass parts of the photocationic-curable resin composition.

When the aromatic ether compound or the aliphatic thioether compound (C) is used in the above amount, the conversion is further improved, and the curing properties can be further enhanced.

### (D) Fine particle inorganic filler

The resin composition of the invention preferably contains a fine particle inorganic filler (D). The fine particle inorganic filler is an inorganic filler having a primary particle average diameter of 0.005 to 10 µm.

Examples of the fillers include silica, talc, alumina, mica and calcium carbonate. As the fine particle inorganic filler, any of surface-treated fillers and surface-untreated fillers is employable. Examples of the surface-treated fine particle inorganic fillers include methoxylated, trimethylsilylated or octylsilylated fine particle inorganic fillers, and fine particle inorganic fillers having been surface-treated with silicone oil.

These finer particle inorganic fillers (D) can be used singly or in combination of two or more kinds.

The fine particle inorganic filler (D) for the resin composition of the invention is desired to be used in an amount of preferably 0 to 70 mass parts, more preferably 0.1 to 70 mass parts, particularly preferably 1 to 30 mass parts.

When the finer particle inorganic filler is added in the above amount, the composition can be enhanced in the moisture permeation resistance, adhesive force and thixotropic properties.

### (E) Silane coupling agent

The photocationic-curable resin composition according to the invention may contain a silane coupling agent (E) when needed. The silane coupling agent (E) is, for example, a silane compound having a reactive group such as an epoxy group, a carboxyl group, a methacryloyl group or an isocyanate group.

Examples of such compounds include trimethoxysilylbenzoic acid, γ-methacryloxypropyltrimethoxysilane, vinyltriacetoxysilane, vinyltrimethoxysilane, γ-isocyanatopropyltriethoxysilane, γ-glycidoxypropyltrimethoxysilane and β-(3,4-epoxycyclohexyl)ethyltrimethoxysilane.

These silane coupling agents (E) can be used singly or in combination of two or more kinds.

The silane coupling agent (E) is desired to be used in an amount of preferably 0 to 10 mass parts, more preferably 0.1 to 10 mass parts, particularly preferably 0.3 to 8 mass parts, based on 100 mass parts of the photocationic-curable resin composition.

When the silane coupling agent (E) is added in the above amount, adhesive force of the composition can be enhanced, so that such an amount is preferable.

Accordingly, it is preferable that in the photocationic-curable resin composition of the invention, the cationic-polymerizable compound (A) is contained in an amount of 5 to 99.8 mass parts, the photocationic initiator (B) is contained in an amount of 0.1 to 10 mass parts, the aromatic ether compound or the aliphatic thioether compound (C) is contained in an amount of 0.01 to 5 mass parts, the fine particle inorganic filler (D) is contained in an amount of 0 to 70 mass parts, and the silane coupling agent (E) is contained in an amount of 0 to 10 mass parts, each amount being based on 100 pars by weight of the photocationic-curable resin composition.

When the fine particle inorganic filler (D) and the silane coupling agent (E) are used in combination, it is preferable that the cationic-polymerizable compound (A) is contained in an amount of 5 to 99.6 mass parts, the photocationic initiator (B) is contained in an amount of 0.1 to 10 mass parts, the aromatic ether compound or the aliphatic thioether compound (C) is contained in an amount of 0.01 to 5 mass parts, the fine particle inorganic filler (D) is contained in an amount of 0.1 to 70 mass parts, and the silane coupling agent (E) is contained in an amount of 0.1 to 10 mass parts, each amount being based on 100 pars by weight of the photocationic-curable resin composition.

In the resin composition of the invention, other components, such as other resin components, filler, modifier, stabilizer and antioxidant, can be contained within limits not detrimental to the effects of the invention.

### Other resin components

Examples of other resin components include polyamide, polyamidoimide, polyurethane, polybutadiene, polychloroprene, polyether, polyester, styrene/butadiene/styrene block copolymer, petroleum resin, xylene resin, ketone resin, cellulose resin, fluorine oligomer, silicon oligomer and polysulfide oligomer.

These resins may be used singly or in combination of plural kinds.

### Filler

Examples of the fillers include glass beads, styrene polymer particles, methacrylate polymer particles, ethylene polymer particles and propylene polymer particles.

These fillers may be used singly or in combination of plural kinds.

### Modifier

Examples of the modifiers include polymerization initiator assistant, anti-aging agent, leveling agent, wettability improver, surface active agent, plasticizer and ultraviolet light absorber.

These modifiers may be used singly or in combination of plural kinds.

### Antioxidant

The antioxidant is, for example, a phenolic compound. Examples of such compounds include hydroquinone, resorcinol, 2,6-di-tert-butyl-p-cresol, 4,4'-thiobis-(6-tert-butyl-3-methylphenol), 4,4'-butylidenebis-(6-tert-butyl-3-methylphenol), 2,2'-methylenebis-(4-methyl-6-tert-butylphenol), 2,6-di-tert-butyl-4-ethylphenol, 1,1,3-tris(2-methyl-4-hydroxy-5-tert-butylphenyl)butane, n-octadecyl-3-(3,5-di-tert-butyl-4-hydroxyphenyl)propionate, tetrakis[methylene-3-(3,5-di-tert-butyl-4-hydroxyphenyl)propionate]methane and triethylene glycol bis[3-(3-tert-butyl-4-hydroxy-5-methylphenyl)propionate].

These compounds may be used singly or in combination of two or more kinds.

### Preparation of photocationic-curable resin composition

The photocationic-curable resin composition according to the invention is prepared by homogeneously blending the components. The viscosity range of 0.01 to 300 Pa·s is preferable because the coating operation can be more efficiently performed and the blending stability of the components is good. The viscosity is more preferably in the range of 0.1 to 100 Pa·s.

The viscosity is controlled by changing the blending ratio of the resin or adding other components.

When the viscosity is high, the components are kneaded by a conventional method such as a three-roll method.

### Sealing material, sealing method, production process, liquid crystal display, and electroluminescent display

The sealing material according to the invention comprises the photocationic-curable resin composition.

The sealing material has a high polymerization conversion of the cationic-polymerizable compound, is excellent in productivity and exhibits excellent adhesive strength and moisture permeation resistance. Therefore, the sealing material is preferable as a liquid crystal display sealing material or an electroluminescent display sealing material.

The display sealing method using the sealing material which comprises the photocationic-curable resin composition is as follows.

In the first step, the liquid crystal display sealing material or the electroluminescent display sealing material according to the invention is applied to or coated on a liquid display substrate or an electroluminescent display substrate.

There is no specific limitation on the method to apply the sealing material provided that the sealing material can be uniformly applied.

For example, a known method such as screen printing or application using a dispenser is carried out.

After application of the sealing material to the display substrate, the substrate is bonded to another display substrate with the sealing material, and the sealing material is irradiated with a light and thereby cured.

As the light source, any of light sources capable of curing the sealing material within a given period of an operation time is employable. Usually, the sealing material can be irradiated with ultraviolet light or light of visible region.

More specifically, a low-pressure mercury lamp, a high-pressure mercury lamp, a xenon lamp, a metal halide lamp or the like is employable.

The quantity of light for the irradiation is usually in the range of 500 to 3000 mJ/cm². If the quantity of light is too small, it can be properly determined so that no uncured resin composition remains or no adhesion failure is brought about.

There is no specific limitation on the upper limit of the quantity of light for the irradiation. However, too large quantity of light is not preferable because of waste of energy and low productivity.

By the above method, opposite substrates for a liquid crystal display or an electroluminescent display can be bonded with the sealing material of the invention.

Such a liquid crystal display sealing method or an electroluminescent display sealing method as mentioned above gives a high polymerization conversion of the cationic-polymerizable compound, is excellent in the productivity and provides a liquid crystal display or an electroluminescent display having excellent adhesive strength and moisture permeation resistance.

The process for producing a liquid crystal display or an electroluminescent display according to the invention is a process comprising bonding opposite substrates for a liquid crystal display or an electroluminescent display with the sealing material of the invention.

The liquid crystal display according to the invention uses the sealing material of the invention as a sealing material to bond the opposite substrates for the liquid crystal display. The electroluminescent display according to the invention uses the sealing material of the invention as a sealing material to bond the opposite substrates for the electroluminescent display.

The photocationic-curable resin composition according to the invention has good conversion (curability) at low temperatures, and its cured product exhibits good adhesive strength and moisture permeation resistance. According to the sealing material comprising the resin composition, a liquid crystal display or an electroluminescent display having good adhesive strength and moisture permeation resistance can be provided with high productivity.

### EXAMPLE

The present invention is further described with reference to the following examples, but it should be construed that the invention is in no way limited to those examples.

### Measuring method

The resin compositions and the cured products obtained in the following examples were evaluated as follows.

### Conversion

From the absorption reduction of the epoxy group or the oxetane group in the IR spectrum, a conversion was calculated.

### Adhesive strength

A resin composition (thickness: 100 µm) was sandwiched between two glass plates and irradiated with light to bond the glass plates. Then, the glass plates were separated from each other at a pulling rate of 2 mm/min to measure an adhesive strength.

### Film moisture permeability

A resin composition film (thickness: 100 µm) having been photo-cured in accordance with JIS Z0208 was measured on the moisture permeability under the conditions of 40°C and 90%RH.

### Example 1

The following compounds were used as starting materials.

### Cationic-polymerizable compound (A)

Epoxy compound a-1: bisphenol F diglycidyl ether Oxetane compound a-2: 1,4-bis[(3-ethyl-3-oxetanylmethoxy)methyl]benzene

### Photocationic initiator (B)

Photo initiator b-1: compound represented by the following formula

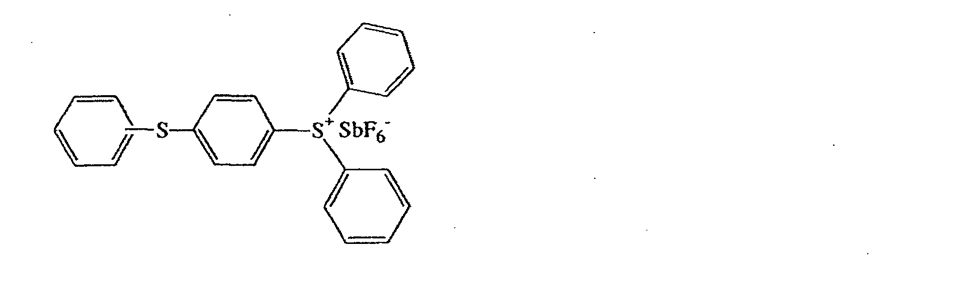

### Aromatic ether compound (c-1)

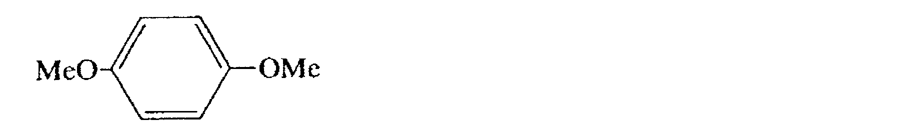

### Fine particle inorganic filler (D)

Fine particle silica d-1: surface-untreated fine particle silica having a primary particle average diameter of 12 nm

### Preparation of resin composition

According to the formulation shown in Table 1, 96.9 mass parts of the compound a-1 (bisphenol F diglycidyl ether) as the component (A) having an oxetane ring, 3 mass parts of the photo initiator b-1 as the component (B) (photocationic initiator) and 0.1 mass part of the compound c-1 as the component (C) (aromatic ether compound or aliphatic thioether compound) were blended and stirred for 1 hour to obtain a transparent liquid composition.

### Photo-curing

The composition was irradiated with a metal halide lamp at 3000 mJ/cm² and thereby cured. The evaluation results are shown in Table 2.

### Examples 2 and 3

A resin composition was prepared in the same manner as in Example 1, except that the formulation was changed as shown in Table 1. Then, the evaluations were carried out in the same manner as in Example 1. The results are shown in Table 2.

### Comparative Examples 1 - 3

A resin composition was prepared in the same manner as in Example 1, except that the formulation was changed as shown in Table 1. Then, the evaluations were carried out in the same manner as in Example 1. The results are shown in Table 2.

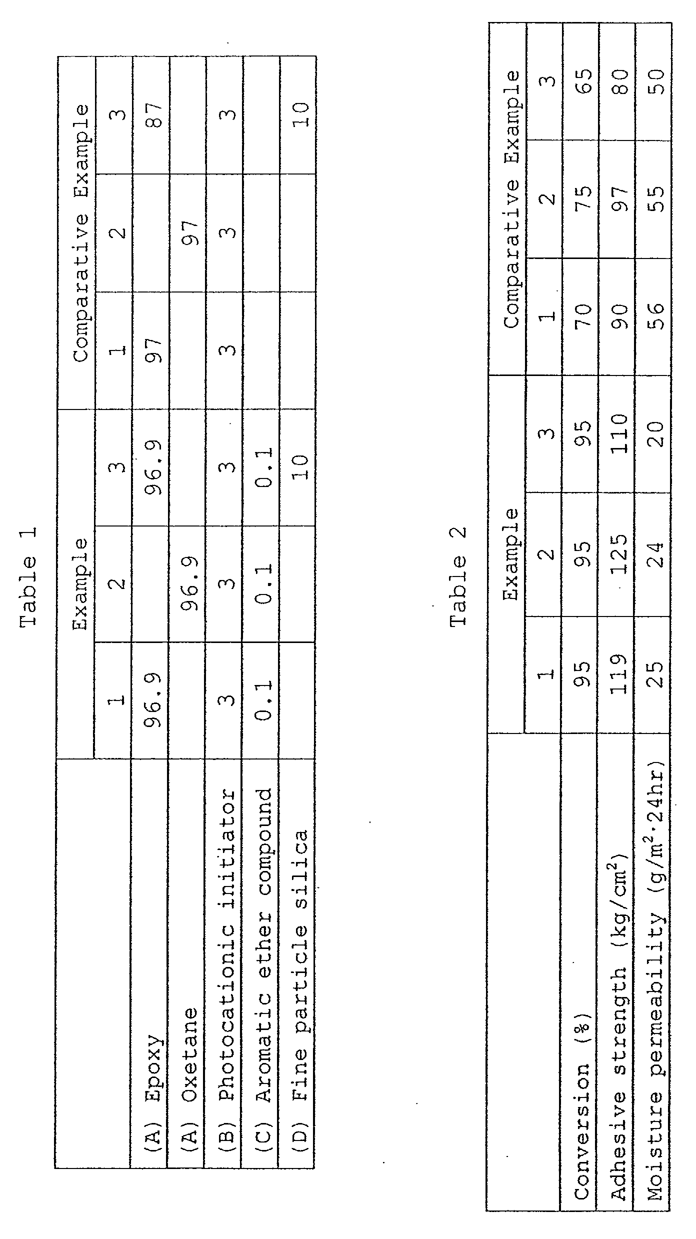

### Example 4

The following compounds were used as starting materials.

### Cationic-polymerizable compound (A)

Epoxy compound a-1: bisphenol F diglycidyl ether

Oxetane compound a-2: 1,4-bis[(3-ethyl-3-oxetanylmethoxy)methyl]benzene

### Photocationic initiator (B)

Photo initiator b-1: compound represented by the following formula

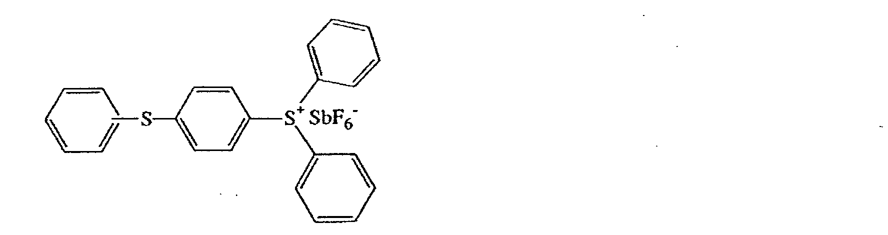

### Aliphatic thioether compound (c-2)

Thiother compound c-2: dilauryl thiodipropionate

### Fine particle inorganic filler (D)

Fine particle silica d-1: surface-untreated fine particle silica having a primary particle average diameter of 12 nm

### Preparation of resin composition

According to the formulation shown in Table 1, 96.9 mass parts of the compound a-1 (bisphenol F diglycidyl ether) as the component (A) having an oxetane ring, 3 mass parts of the photo initiator b-1 as the component (B) (photocationic initiator) and 0.1 mass part of the compound c-2 (dilauryl thiodipropionate) as the component (C) (aliphatic thioether) were blended and stirred for 1 hour to obtain a transparent liquid composition.

### Photo-curing

The composition was irradiated with a metal halide lamp at 3000 mJ/cm² and thereby cured. The evaluation results are shown in Table 3.

### Example 5

A resin composition was prepared in the same manner as in Example 4, except that the formulation was changed as shown in Table 3. Then, the evaluations were carried out in the same manner as in Example 1. The results are shown in Table 4.

### Comparative Examples 4 - 6

A resin composition was prepared in the same manner as in Example 4, except that the formulation was changed as shown in Table 3. Then, the evaluations were carried out in the same manner as in Example 1. The results are shown in Table 4.

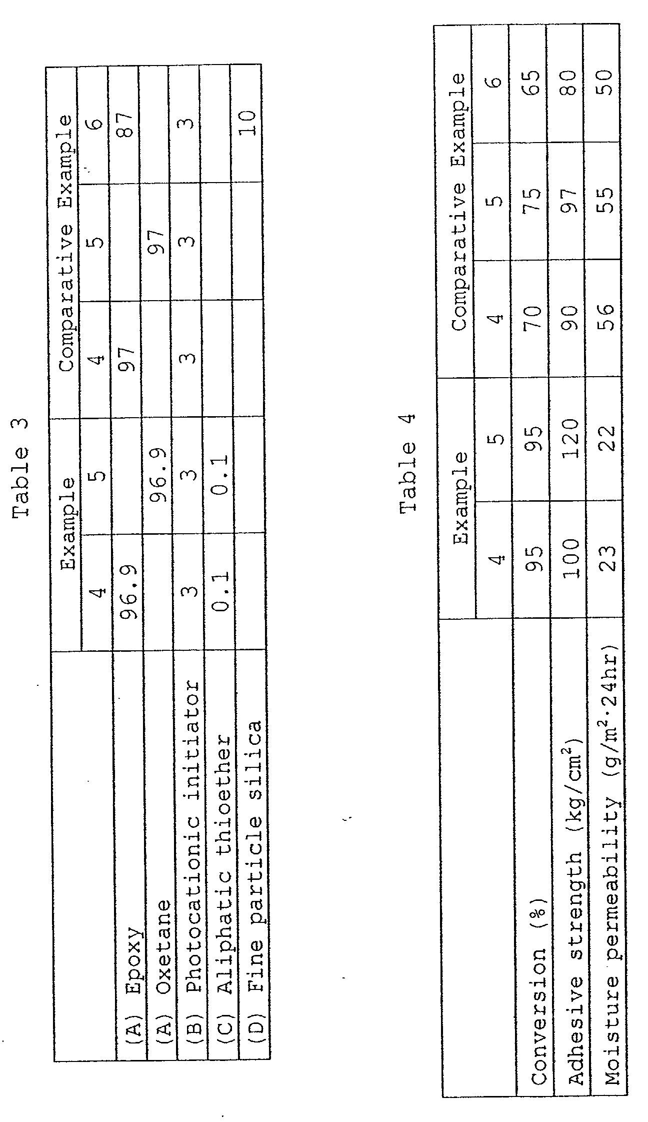

## Claims

1. A photocationic-curable resin composition comprising:
(A) a cationic-polymerizable compound,
(B) a photocationic initiator, and
(C) an aromatic ether compound (c-1) or an aliphatic thioether compound (c-2).

2. The photocationic-curable resin composition as claimed in claim 1, wherein the aromatic ether compound . (c-1) is at least one aromatic ether compound selected from the group consisting of compounds represented by the following formulas (I), (II) and (III): 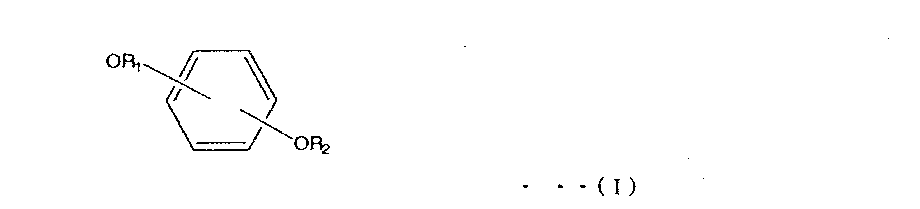 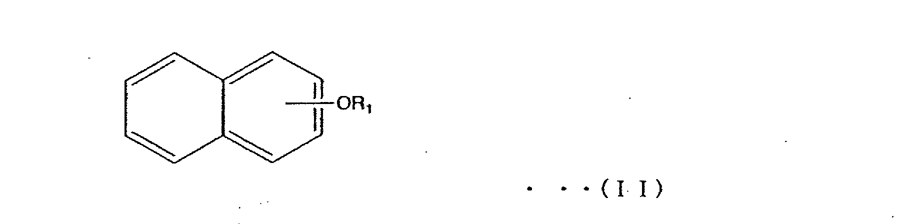 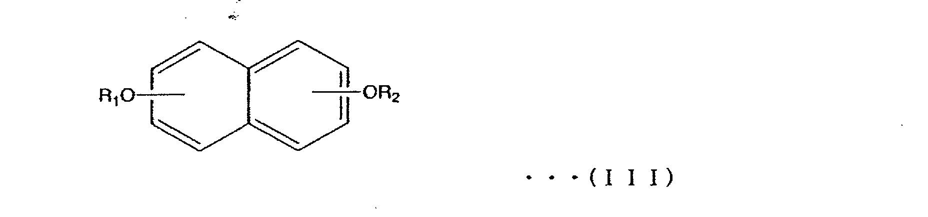 wherein R₁ and R₂ in the formulas (I), (II) and (III) are each an alkyl group of 1 to 5 carbon atoms, a glycidyl group or a 3-ethyl-3-oxetanylmethyl group, and R₁ and R₂ in the formulas (I) and (III) may be the same or different.

3. The photocationic-curable resin composition as claimed in claim 1, wherein the aliphatic thioether compound (c-2) is a compound represented by the following formula (IV): 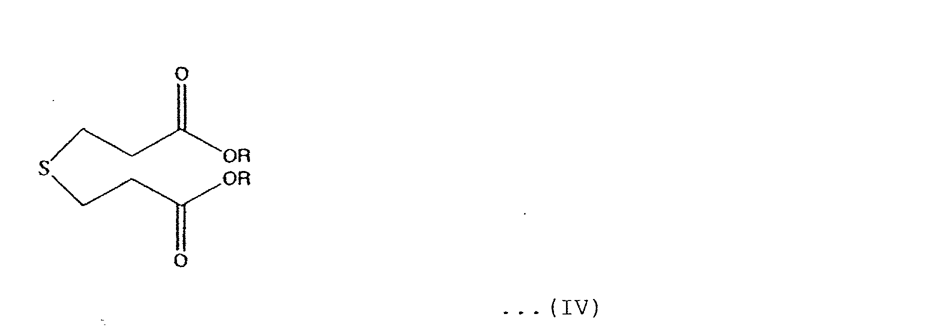 wherein R is an alkyl group of 1 to 18 carbon atoms.

4. The photocationic-curable resin composition as claimed in any one of claims 1 to 3, wherein the cationic-polymerizable compound (A) is an epoxy compound and/or an oxetane compound.

5. The photocationic-curable resin composition as claimed in any one of claims 1 to 4, wherein the aromatic ether compound or the aliphatic thioether compound (C) is contained in an amount of 0.01 to 5 mass parts based on 100 mass parts of the photocationic-curable resin composition.

6. The photocationic-curable resin composition as claimed in any one of claims 1 to 5, further comprising (D) a fine particle inorganic filler.

7. The photocationic-curable resin composition as claimed in any one of claims 1 to 6, further comprising (E) a silane coupling agent.

8. The photocationic-curable resin composition as claimed in any one of claims 1 to 7, wherein the cationic-polymerizable compound (A) is contained in an amount of 5 to 99.8 mass parts, the photocationic initiator (B) is contained in an amount of 0.1 to 10 mass parts, the aromatic ether compound or the aliphatic thioether compound (C) is contained in an amount of 0.01 to 5 mass parts, the fine particle inorganic filler (D) is contained in an amount of 0 to 70 mass parts, and the silane coupling agent (E) is contained in an amount of 0 to 10 mass parts, each amount being based on 100 mass parts of the photocationic-curable resin composition.

9. A liquid crystal display sealing material comprising the photocationic-curable resin composition of any one of claims 1 to 8.

10. A liquid crystal display sealing method comprising bonding opposite substrates for a liquid crystal display to each other with a sealing material, wherein the liquid crystal display sealing material of claim 9 is used as the sealing material.

11. A process for producing a liquid crystal display, including a step of bonding opposite substrates for a liquid crystal display to each other with a sealing material, wherein the liquid crystal display sealing material of claim 9 is used as the sealing material.

12. A liquid crystal display using the liquid crystal display sealing material of claim 9 as a sealing material to bond opposite substrates for a liquid crystal display.

13. An electroluminescent display sealing material comprising the photocationic-curable resin composition of any one of claims 1 to 8.

14. An electroluminescent display sealing method comprising bonding opposite substrates for an electroluminescent display to each other with a sealing material, wherein the electroluminescent display sealing material of claim 13 is used as the sealing material.

15. A process for producing an electroluminescent display, including a step of bonding opposite substrates for an electroluminescent display to each other with a sealing material, wherein the electroluminescent display sealing material of claim 13 is used as the sealing material.

16. An electroluminescent display using the electroluminescent display sealing material of claim 13 as a sealing material to bond opposite substrates for an electroluminescent display.
